# EUROPEAN PATENT APPLICATION

(11) **EP 1 912 251 A2**
(43) Date of publication of application: **16.04.2008**
(21) Application number: 07019861.9
(22) Date of filing: 10.10.2007
(51) Int. Cl.: H01L 21/02, H01L 27/06, H01L 23/522

(54) **Resistor in a wiring layer and manufacturing method of the same**

(30) Priority: 10.10.2006 JP 2006276528
(71) Applicant: Sanyo Electric Co., Ltd., Osaka 570-8677 (JP); Sanyo Semiconductor Co., Ltd., Oizumi-machi Ora-gun Gunma-ken 370-0596 (JP)
(72) Inventor: Sato, Yoshinori, Gunma 370-0727 (JP); Ohne, Naoki, Gunma 370-0517 (JP); Yamamae, Takeshi, Gunma 370-0533 (JP)
(74) Representative: Riesenberg, Axel

(57) **Abstract**

Provided is a semiconductor device that solves the problem of a conventional semiconductor device. In the conventional semiconductor device, a resistor is connected with a wiring layer via a contact hole, so that a reduction in parasitic capacitance of the resistor and a substrate is hard to be accomplished. In the semiconductor device of the present invention, a resistor (25) made of a titanium nitride (TiN) film is directly connected with wiring layers (28, 29) on an insulating layer (26). This structure contributes to an increase in the contact area between the resistor (25) and the wiring layers (28, 29), and then to a reduction in the contact resistance. Furthermore, a broader separation distance between the resistor (25) and an epitaxial layer (3) contributes to a reduction in the parasitic capacitance in the resistor (25) and to an improvement in the high-frequency characteristics of the semiconductor device.

## Description

### Field of the Invention

The present invention relates to a semiconductor device capable of reducing the parasitic capacitance of a resistor and a semiconductor substrate while reducing the variations in resistance of the resistor. The invention also relates to a method of manufacturing such a semiconductor device.

### Description of the Related Art

What follows is a method of manufacturing a polysilicon resistor that is known as an example of a conventional method of manufacturing a semiconductor device. To begin with, an element-separation film is formed on a silicon substrate by, for example, an LOCOS method and thus a first element region is separated from the rest of the regions. To form an MOS transistor in the first element region, a gate oxide film is formed on the first element region, and then, a polysilicon film is formed on the first element region including on the gate oxide film. Subsequently, the polysilicon film is etched using a resist pattern as a mask. A gate electrode is thus formed on the first element region while a polysilicon resistor is formed on the element separation film. Thereafter, an interlayer insulating film is formed on top of the silicon substrate by, for example, a CVD method, and then contact holes are formed in a desired region of the interlayer insulating film. Subsequently, an aluminum-alloy film is formed inside the contact holes and on the interlayer insulating film by, for example, a sputtering method. The aluminum-alloy film on the interlayer insulating film is then etched using a resist pattern as a mask. A wiring layer is thus formed. (This technology is described for instance in Japanese Patent Application Publication No. 2006-80218, esp. pp.6-7, Figs. 1-2).

What follows is a resistor that is known as an example of a conventional semiconductor device. An n type epitaxial layer is formed on a p type semiconductor substrate. The epitaxial layer is divided into a plurality of regions by isolation layers. On the epitaxial layer, an insulating layer is formed, and in a desired region on the insulating layer, a resistor is formed. The resistor is made of the same material as the polysilicon that is used as a material for the gate electrode in a CMOS integrated circuit. Alternatively, the resistor is made of a metal material. On the resistor, an insulating layer is formed, and in the insulating layer, contact holes are formed. On the insulating layer in which the contact holes are formed, a wiring layer is formed. The resistor and this wiring layer are connected with each other via the contact hole (This technology is described for instance in Japanese Patent Application Publication No. 2001-127167, esp. page.3, Figs. 1).

In a conventional semiconductor device, as described above, an insulating layer is formed on a semiconductor substrate, and on the insulating layer, a resistor is formed of, for example, a polysilicon film. Another insulating layer is formed on the resistor, and on this insulating layer, a wiring layer is formed. A contact hole is formed in the insulating layer to connect the resistor and the wiring layer with each other. In this structure, the resistor is located, within the insulating layer, in a region on a side closer to the substrate. Accordingly, a problem arises in that the parasitic capacitance of the resistor and the substrate (or the epitaxial layer) is hard to be reduced.

Additionally, in a conventional semiconductor device, a resistor is formed, for example, in the common process in which the gate electrode of the MOS transistor is formed. In this structure, it is difficult to place the resistor at a position separated far away enough from the substrate (or the epitaxial layer) to reduce the parasitic capacitance of the resistor and the substrate (or the epitaxial layer). This causes the difficulty in improving the high-frequency characteristics.

Moreover, in a conventional method of manufacturing a semiconductor device, a contact hole is formed in an insulating layer that is formed on a resistor, and via the contact hole, the resistor and a wiring layer are connected with each other. Here, the region closer to the substrate (or the epitaxial layer) is subject to especially strict design rules, and requires a micro-fabrication technique. That is why the contact hole is formed by a dry etching method. The use of this manufacturing method renders the opening area of the contact hole narrower, so that the area where the resistor and the wiring layer are in contact with each other is also made narrower. This results in the difficulty in reducing the contact resistance. It is an object of this invention to provide a semiconductor device and manufacturing method that lessen this drawback.

### SUMMARY OF THE INVENTION

The solution according to the present invention resides in features of the independent claims and preferably in those of the dependent claims. An aspect of the invention provides a semiconductor device that includes a semiconductor layer, an insulating layer formed on the semiconductor layer, a resistor formed on the insulating layer, and a wiring layer connected with the resistor. In the semiconductor device, the wiring layer is disposed on the same insulating layer that the resistor is disposed on. In the semiconductor device of the aspect of the invention, the resistor is directly connected with the wiring layer with no contact hole formed on the resistor. This structure contributes to an increase in the contact area between the resistor and the wiring layer, and to a reduction in the contact resistance.

In the semiconductor device according to an aspect of the invention, the resistor of the semiconductor device is made of a metal film. Accordingly, in the aspect of the invention, the resistor is disposed in a region where the wiring layer is formed, and thus is disposed as being separated far away from the semiconductor layer. As a result, the parasitic capacitance of the resistor and the semiconductor layer is reduced.

In the semiconductor device according to an aspect of the invention, the wiring layer that is positioned on the resistor is processed by wet-etching. According to the aspect of the invention, the resistor is prevented from being over-etched. This results in a reduction in the variations in resistance of the resistor.

In the semiconductor device according to an aspect of the invention, a multi-layer wiring structure is formed on the semiconductor layer, and the wiring layer is the uppermost one of the wiring layers within the multi-layer wiring structure. According to the aspect of the invention, the resistor is disposed, within the multi-layer wiring structure, in a region where the uppermost one of the wiring layers is formed. As a result, the parasitic capacitance in the resistor and the semiconductor layer is reduced, and the high-frequency characteristics are improved.

In the semiconductor device according to an aspect of the invention, a multi-layer wiring structure is formed on the semiconductor layer, and the wiring layer is any one of the wiring layers within the multi-layer wiring structure. According to the aspect of the invention, the resistor is disposed, within the multi-layer structure, at a desired position on the insulating layer.

In the semiconductor device according to an aspect of the invention, the resistor is made of any one of titanium, titanium nitride, tantalum, and tantalum nitride. According to the aspect of the invention, the resistor is prevented from being etched when the wiring layer is etched. This results in a reduction in the variations in resistance of the resistor.

A method of manufacturing a semiconductor device according to an aspect of the invention includes a step of depositing an insulating layer on the semiconductor layer, then forming a resistor on the insulating layer, and then forming, on the insulating layer, a metal layer that forms a wiring layer so as to cover at least the resistor. Also included is a step of wet-etching the metal layer by use of the resistor as an etching stopper, so as to form a wiring layer that enables two different voltages to be applied to the resistor. According to the aspect of the invention, the resistor is used as an etching-stopper film when the wiring layer connected with the resistor is etched. By this manufacturing method, the resistor is prevented from being over-etched, and the variations in the resistance of the resistor can be prevented.

### BRIEF DESCRIPTION OF THE DRAWINGS

Fig. 1 is a cross-sectional view for describing a semiconductor device according to a preferred embodiment of the invention.
Figs. 2A and 2B are plan views each for describing the semiconductor device according to the preferred embodiment of the invention.
Fig. 3 is a cross-sectional view for describing the semiconductor device according to the preferred embodiment of the invention.
Fig. 4 is a cross-sectional view for describing a method of manufacturing a semiconductor device according to a preferred embodiment of the invention.
Fig. 5 is a cross-sectional view for describing the method of manufacturing a semiconductor device according to the preferred embodiment of the invention.
Fig. 6 is a cross-sectional view for describing the method of manufacturing a semiconductor device according to the preferred embodiment of the invention.
Fig. 7 is a cross-sectional view for describing the method of manufacturing a semiconductor device according to the preferred embodiment of the invention.
Fig. 8 is a cross-sectional view for describing the method of manufacturing a semiconductor device according to the preferred embodiment of the invention.
Fig. 9 is a cross-sectional view for describing the method of manufacturing a semiconductor device according to the preferred embodiment of the invention.

### DETAILED DESCRIPTION OF THE PREFERRED EMBODIMENTS

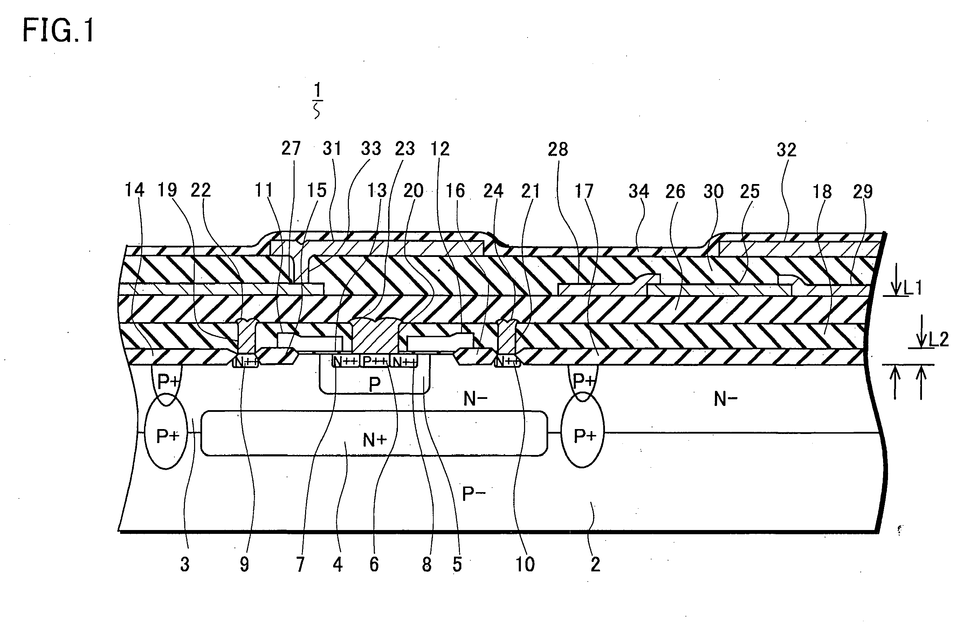

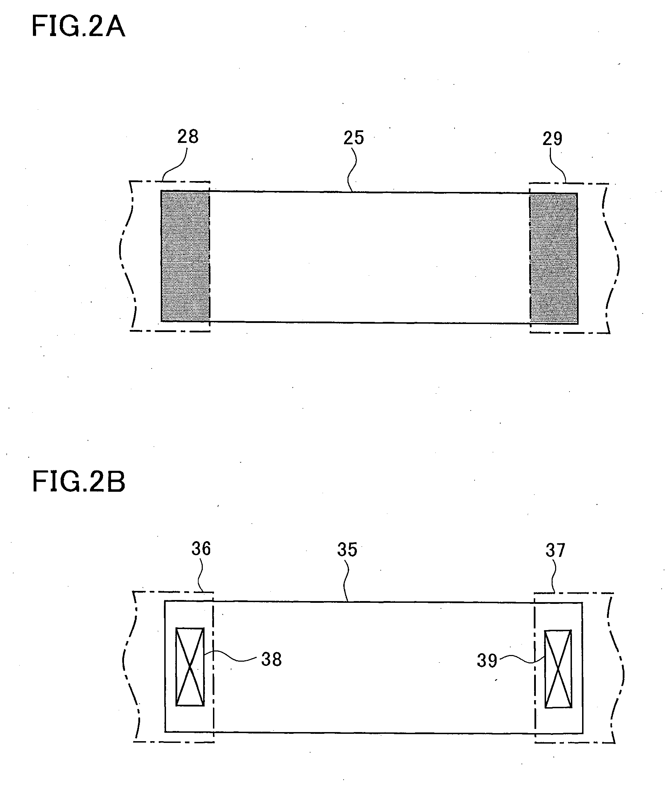

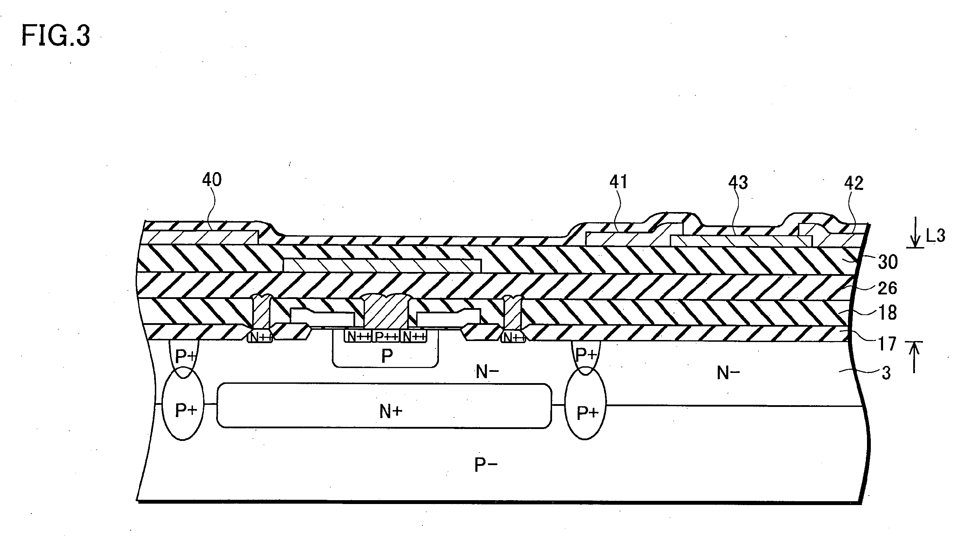

Now, what follows is a detailed description of a semiconductor device according to an embodiment of the present invention with reference to Figs. 1 to 3. Fig. 1 is a cross-sectional view for describing a semiconductor device according to this embodiment. Fig. 2A is a plan view for describing a structure in which a resistor and a wiring layer are in direct contact with each other. Fig. 2B is a plan view for describing a structure in which a resistor and a wiring layer are in contact with each other via a contact hole. Fig. 3 is a cross-sectional view for describing the semiconductor device according to this embodiment.

Fig. 1 shows the structure of an n channel type MOS transistor 1. The n channel type MOS transistor 1 includes a p type single-crystal silicon substrate 2, an n type epitaxial layer 3, an n type buried diffusion layer 4, p type diffusion layers 5 and 6 that are used as back-gate regions, n type diffusion layers 7 and 8 that are used as source regions, n type diffusion layers 9 and 10 that are used as drain regions, and gate electrodes 11 and 12.

The n type epitaxial layer 3 is formed on the p type single-crystal silicon substrate 2. Note that, in this embodiment, only a single layer of the epitaxial layer 3 is formed on the substrate 2, but the embodiment of the present invention is not limited to this structure. For example, in an allowable structure, a plurality of epitaxial layers are formed in the substrate.

The n type buried diffusion layer 4 is formed in both regions of the substrate 2 and the epitaxial layer 3. As shown in Fig. 1, the n type buried diffusion layer 4 is formed across the region in which the n channel type MOS transistor 1 is formed.

The p type diffusion layer 5 is formed in the epitaxial layer 3. In the p type diffusion layer 5, the p type diffusion layer 6 is formed with its formation region being overlaid with the p type diffusion layer 5. The p type diffusion layer 5 is used as a back-gate region while the p type diffusion layer 6 is used as a back-gate lead-out region. Parts of the p type diffusion layer located below the gate electrodes 11 and 12 are used as channel regions.

The n type diffusion layers 7 and 8 are formed in the p type diffusion layer 5, and are used as source regions. The n type diffusion layers 7 and 8 as well as p type diffusion layer 6 are connected with the source electrode 23, and have equal potentials. Note that the n type diffusion layers 7 and 8 may be formed into a single ring shape surrounding the p type diffusion layer 6.

The n type diffusion layers 9 and 10 are formed in the epitaxial layer 3, and are used as drain regions.

The gate electrodes 11 and 12 are formed each on the top surface of a gate oxide film 13. Each of the gate electrodes 11 and 12 is formed of a polysilicon film in a desired film thickness. Note that the gate electrodes 11 and 12 may be formed in a single ring shape.

Local oxidation of silicon (LOCOS) oxide films 14, 15, 16, and 17 are formed in the epitaxial layer 3. The film thickness of the flat portion of each of the LOCOS oxide films 14, 15, 16, and 17 is, for example, approximately 3000 to 5000 Å.

An insulating layer 18 is formed on top of the epitaxial layer 3, and is formed of, for example, a boron phospho silicate glass (BPSG) film, or a phospho silicate glass (PSG) film. Contact holes 19, 20, and 21 are formed in the insulating layer 18 by a known photolithography technique and by a dry etching method using, for example, a CHF₃ gas or a CF₄ gas.

Aluminum-alloy films are selectively formed inside the contact holes 19, 20, and 21 to form drain electrodes 22 and 24 as well as a source electrode 23. Such aluminum-alloy films are formed, for example, of an Al-Si film, an Al-Si-Cu film, and an Al-Cu film. The drain electrodes 22 and 24 as well as the source electrode 23 are formed in the common process in which the first one of the wiring layers (not illustrated) is formed. Note that the drain electrodes 22 and 24 may be formed in a single ring shape surrounding the source electrode 23. Though no wiring layer connected with the gate electrodes 11 and 12 is shown in the cross section shown in Fig. 1, the gate electrodes 11 and 12 are connected with the wiring layer in a region that is not shown in the drawing.

Fig. 1 shows that a resistor 25 is formed on an insulating layer 26. The resistor 25 is formed, for example, of a titanium nitride (TiN) film.

The insulating layer 26 is formed on the insulating layer 18, and is formed, for example, of a tetra-ethyl-orso-silicate (TEOS) film, or a spin on glass (SOG) film.

Second wiring layers 27, 28, and 29 are formed on the insulating layer 26. The wiring layers 27, 28, and 29 are formed of aluminum-alloy films, such as an Al-Si film, an Al-Si-Cu film, and an Al-Cu film. A high voltage, such as a power supply voltage, is applied on the resistor 25 via the wiring layer 28 while the wiring layer 29 is used to apply a low voltage, such as the ground voltage, to the resistor 25.

An insulating layer 30 is formed on top of the insulating layer 26. The insulating layer 30 is formed, for example, of a TEOS film, or a SOG film. The insulating layer 30 covers the second wiring layers 27, 28, and 29 and the resistor 25.

Third wiring layers 31 and 32 are formed on the insulating layer 30. The wiring layers 31 and 32 are formed of aluminum-alloy films, such as an Al-Si film, an Al-Si-Cu film, and an Al-Cu film. A contact hole 33 is formed in the insulating layer 30 to connect the wiring layer 27 of the second ones of the wiring layers with the wiring layer 31 of the third ones of the wiring layers. The contact hole 33 is buried with the aluminum-alloy film when the third wiring layers 31 and 32 are formed.

A silicon nitride film 34 is formed on top of the insulating layer 30. The silicon nitride film 34 is formed covering the third wiring layers 31 and 32. The silicon nitride film is formed all over the top surface of the insulating layer 30 for the purpose, for example, of improving the moisture resistance.

As described above, the resistor 25 is formed by selectively removing the titanium nitride (TiN) film formed on the insulating layer 26. On the insulating layer 26, the resistor 25 is directly connected with the wiring layers 28 and 29. To put it other way, though the resistor 25 is supposed to be connected with the wiring layers 28 and 29 via a contact hole in the conventional structure, the connection is accomplished without such a contact hole in this embodiment.

Specifically, as Fig. 2A shows, the resistor 25 is connected with the wiring layers 28 and 29 on the same plane on the insulating layer 26. Accordingly, as shown by the hatching in the drawing, the contact area of the resistor 25 with each of the wiring layers 28 and 29 is broad. Note that Fig. 2A is a plan view and that the contact area of the resistor 25 with each of the wiring layers 28 and 29 extends to the side surfaces of the resistor 25. Fig. 2B shows that a resistor 35 is connected with wiring layers 36 and 37 via contact holes 38 and 39, respectively. Though not illustrated, an insulating layer is formed on the resistor 35, and the wiring layers 36 and 37 are formed on the insulating layer. Accordingly, the opening area of each of the contact holes 38 and 39 serves as the contact area of the resistor 35 with each of the wiring layers 36 and 37 respectively.

As described above, the resistor 25 has a broader contact area with each of the wiring layers 28 and 29, so that the contact resistance between the resistor 25 and each of the wiring layers 28 and 29 can be reduced significantly.

The direct connection of the resistor 25 with the wiring layers 28 and 29 without contact holes allows the resistor 25 to be placed in an area that is separated far away from the epitaxial layer 3. In this structure, the separation distance L1 between the resistor 25 and the epitaxial layer 3 is equal to the sum of the thicknesses of the LOCOS oxide film 17 and of the insulating layers 18 and 26. Alternatively, a resistor (not illustrated) can be formed using a polysilicon film in the common process in which the gate electrodes 11 and 12 of the n channel type MOS transistor 1 are formed. In this case, the resistor is disposed on the LOCOS oxide film 17, so that the separation distance L2 between the resistor and the epitaxial layer 3 is equal to the thickness of the LOCOS oxide film 17. As described above, widening the separation distance L1 between the resistor 25 and the epitaxial layer 3 can reduce the parasitic capacitance of the resistor 25 and the epitaxial layer 3. Consequently, the high-frequency characteristics of the semiconductor device can be improved.

In a case of a multi-layer wiring structure, specifically a three-layer wiring structure shown in Fig. 3, a resistor 43 can be formed in a region where the third wiring layers 40, 41, and 42 are to be formed. Though a detail description for this is to be given later together with a description of a method of manufacturing a semiconductor device, the wiring layers 41 and 42 connected with the resistor 43 are formed by a wet etching method. The resistor 43 is thus disposed on the insulating layer 30, so that the separation distance L3 between the resistor 43 and the epitaxial layer 3 is equal to the sum of the thicknesses of the LOCOS oxide film 17 and of the insulating layers 18, 26, and 30. In this structure, widening the separation distance L3 between the resistor 43 and the epitaxial layer 3 can reduce the parasitic capacitance between the resistor 43 and the epitaxial layer 3. Incidentally, the resistor 43 is a titanium nitride (TiN) film. The n channel type MOS transistor, the LOCOS oxide film 17, the insulating layers 18, 26, and 30, and the like form the same structure as that shown in Fig. 1. Accordingly, to describe these components, descriptions for the structure of Fig. 1 can be referred to, and descriptions for the structure of Fig. 3 are omitted.

In this embodiment, the resistors 25 and 43 are made of titanium nitride (TiN) films, but the material for the resistors 25 and 43 is not limited to this. For example, the resistors 25 and 43 may be made of a material which is not etched during the wet etching process of the wiring layers connected with the resistors and which has a high melting point. Specifically, a titanium (Ti) film, a tantalum (Ta) film, or a tantalum nitride (TaN) film may be used. In addition, in this embodiment, descriptions have been given of a multi-layer wiring structure of three wiring layers, but the embodiment of the invention is not limited to this structure. The embodiment of the invention is applicable to a single-layer wiring structure. The embodiment of the invention is also applicable to multi-layer structures such as a dual-layer wiring structure and wiring structures with four or more wiring layers. The positions at which the resistors 25 and 43 are formed are not limited to the intermediated wiring layer and the upper most wiring layer within the multi-layer wiring structure. The first ones of the wiring layers may also be used for this purpose. Other modifications are possible without departing from the gist of the embodiment of the present invention.

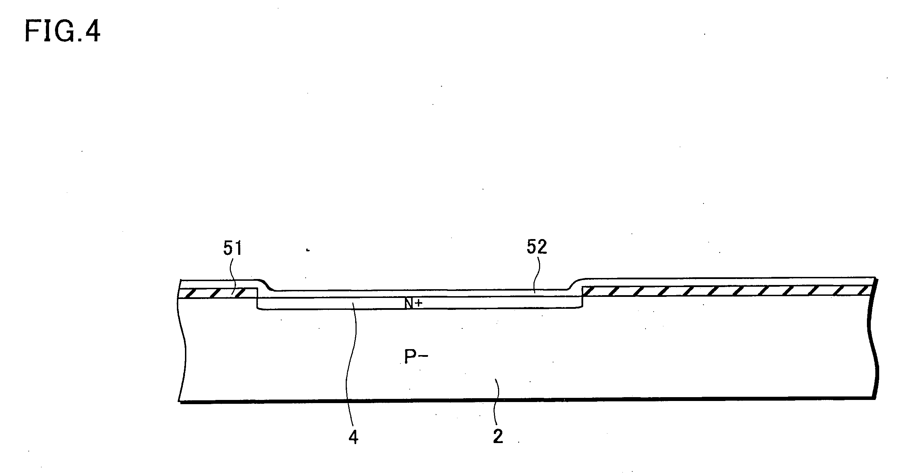

Subsequently, detail descriptions will be given of a method of manufacturing a semiconductor device with reference to Figs. 4 to 9. Figs. 4 to 9 are cross-sectional views for describing the method of manufacturing a semiconductor device according to this embodiment. Note that the manufacturing method that is described with reference to Figs. 4 to 9 is for the semiconductor device shown in Fig. 1.

Firstly, the p type single-crystal silicon substrate 2 is processed to be in a state shown in Fig. 4. A silicon oxide film 51 is formed on the substrate 2, and is selectively removed so as to form an opening portion in a region where the n type buried diffusion layer 4 is to be formed. Then, using the silicon oxide film 51 as a mask, a liquid source 52 containing an n type impurity, such as antimony (Sb), is applied to the surface of the substrate 2 by a spin-coating method. Thereafter, the antimony is thermally diffused to form the n type buried diffusion layer 4. After that, the silicon oxide film 51 and the liquid source 52 are removed.

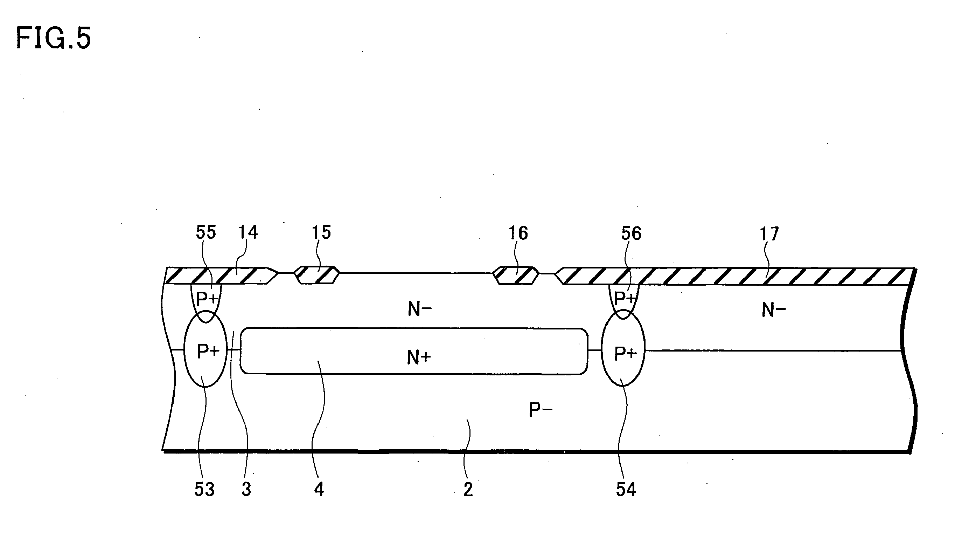

Subsequently, p type buried diffusion layers 53 and 54 are formed using a known photolithography technique, as shown in Fig. 5. The substrate 2 is then placed on the susceptor of a vapor-phase epitaxial-growth apparatus to form the n type epitaxial layer 3 on the substrate 2. The vapor-phase epitaxial-growth apparatus is composed mainly of a gas supply system, a reactor, a gas outlet system, and a control system. In this embodiment, a vertical type reactor is used so as to improve the uniformity in the film thickness of the epitaxial layer. By the heat treatment in the formation of the epitaxial layer 3, the n type buried diffusion layer 4 as well as the p type buried diffusion layers 53 and 54 are thermally diffused.

Subsequently, p type diffusion layers 55 and 56 are formed in the epitaxial layer 3 by a known photolithography technique. Thereafter, LOCOS oxide films 14, 15, 16, and 17 are formed in desired regions of the epitaxial layer 3.

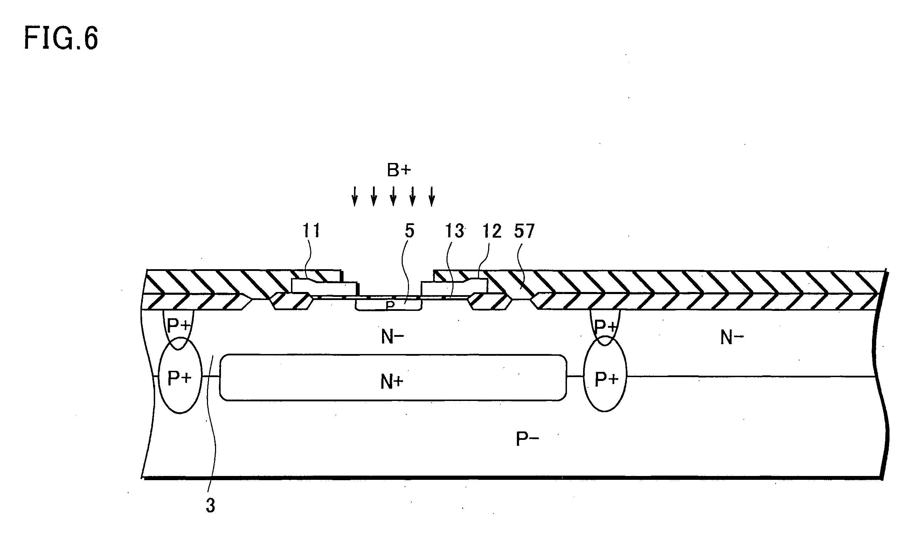

Subsequently, as shown in Fig. 6, silicon oxide film to be used as the gate oxide film 13 is formed on the epitaxial layer 3 in, for example, a thickness of 100 to 200 Å approximately. Then, a polysilicon film is formed on the silicon oxide film in, for example, a thickness of 1000 to 4000 Å approximately. Thereafter, the polysilicon film is selectively removed by a known photolithography technique to form the gate electrodes 11 and 12.

Subsequently, a photoresist 57 is formed on the silicon oxide film that is to be used as the gate oxide film 13. An opening portion is formed, by a known photolithography technique, in the photoresist 57, specifically, in the region thereof where p type diffusion layer 5 is to be formed. Then, ion implantation is carried out from the top-surface side of the epitaxial layer 3. P type impurities, such as boron (B) ions, are implanted with the acceleration voltage of 60 to 90 keV with a dose of 1.0 × 10¹⁴ to 1.0 × 10¹⁶ cm⁻². Thereafter, the photoresist 57 is removed, and a thermal diffusion process is carried out to form the p type diffusion layer 5. Here, the p type diffusion layer 5 is self-alignedly formed using the gate electrodes 11 and 12 as masks.

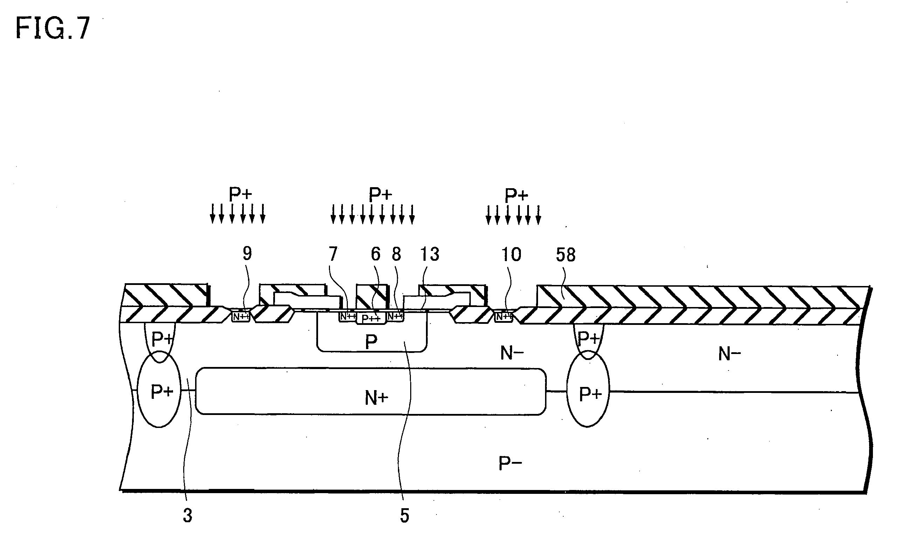

Subsequently, as shown in Fig. 7 the p type diffusion layer 6 is formed in the epitaxial layer 3 by a known photolithography technique. A photoresist 58 is formed on the silicon oxide film that is to be used as the gate oxide film 13. Opening portions are formed, by a known photolithography technique, in the photoresist 58, specifically in regions thereof where the n type diffusion layers 7, 8, 9, and 10 are to be formed. Then, ion implantation is carried out from the top-surface side of the epitaxial layer 3. N type impurities, such as phosphorus (P) ions are implanted with the acceleration voltage of 90 to 110 keV with a dose of 1.0 × 10¹⁴ to 1.0 × 10¹⁶ cm⁻². Thereafter, the photoresist 58 is removed, and a thermal diffusion process is carried out to form the n type diffusion layers 7, 8, 9, and 10.

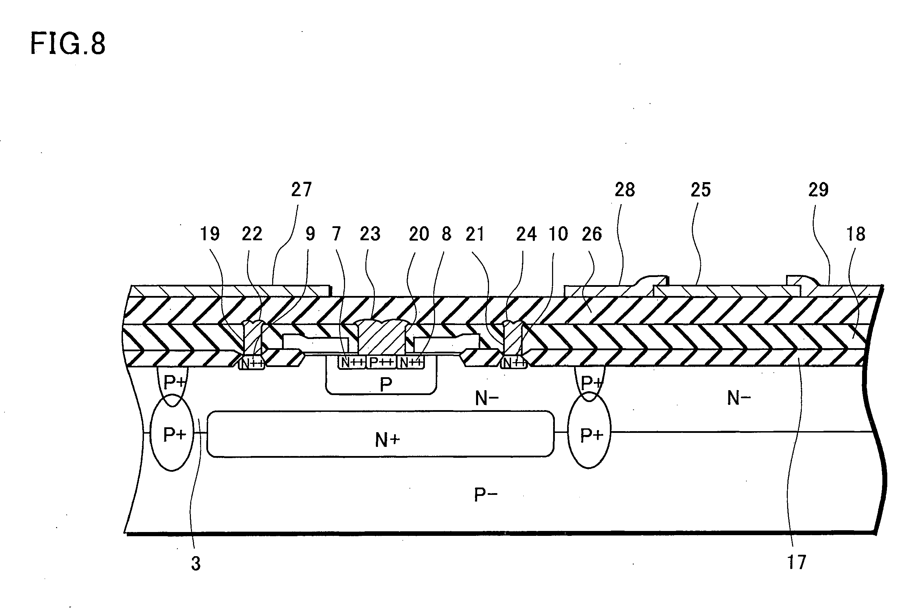

Subsequently, as shown in Fig. 8, a BPSG film, a PSG film, or the like is deposited as the insulating layer 18 on the epitaxial layer 3. The contact holes 19, 20, and 21 are then formed in the insulating layer 18 by a known photolithography technique, such as a dry etching method using a CHF₃ gas or a CF₄ gas. Inside the contact holes 19, 20, and 21, an aluminum-alloy film, such as an Al-Si film, an Al-Si-Cu film, and an Al-Cu film, is selectively formed, and thus the drain electrodes 22 and 24 as well as the source electrode 23 are formed. In this event, the drain electrodes 22 and 24 as well as the source electrode 23 are formed in the common process in which the first one of the wiring layers (not illustrated) is formed. Note that the surface of the insulating layer 18 is made to be flat by depositing a BPSG film, a PSG film, or the like.

Subsequently, a TEOS film, an SOG film, or the like is deposited as the insulating layer 26 on the insulating layer 18. On the insulating layer 26, a titanium nitride (TiN) film is formed by, for example, a sputtering method. The titanium nitride (TiN) film is then selectively removed by a known photolithography technique so as to form the resistor 25 above the region where the LOCOS oxide film 17 is formed. Thereafter, on the insulating layer 26 including the resistor 25, an aluminum-alloy film such as an Al-Si film, an Al-Si-Cu film, and an Al-Cu film, is formed by, for example, a sputtering method. The aluminum-alloy film is then selectively removed by a known photolithography technique, such as a wet etching method using an SC-1 etchant, to form the second wiring layers 27, 28, and 29. Note that the surface of the insulating layer 26 is made to be flat by depositing a TEOS film, an SOG film, or the like.

In this event, on the upper surface of the region where the resistor 25 is formed, some of the second wiring layers 28 and 29 are formed using the resistor 25 as an etching-stopper film. Accordingly, in this embodiment, the resistor 25 is in direct contact with the wiring layers 28 without using any contact hole on the insulating layer 26. In addition, the selectivity with the titanium nitride (TiN) film forming the resistor 25 and with the aluminum-alloy film forming the wiring layers 28 and 29 needs to be taken into account when the etchant is used. According to this manufacturing method, the resistor 25 is prevented from being over-etched while the second wiring layers 27, 28, and 29 are formed. As a result, the variations in the resistance of the resistor 25 can be prevented.

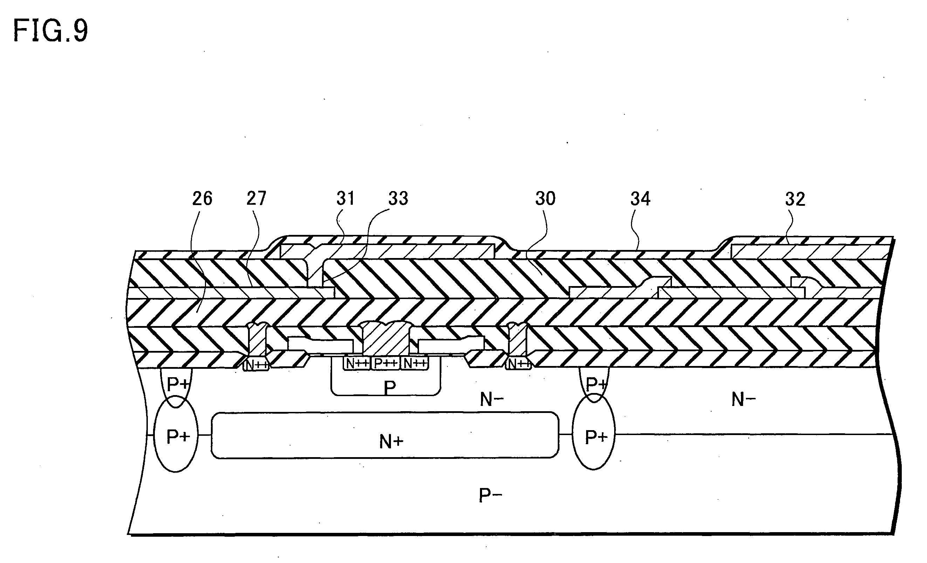

Finally, as shown in Fig. 9, a TEOS film, an SOG film, or the like is deposited as the insulating layer 30 on the insulating layer 26. The contact hole 33 is then formed in the insulating layer 30 by a known photolithography technique, such as a dry etching method using a CHF₃ gas or a CF₄ gas. In addition, an aluminum-alloy film, such as an Al-Si film, an Al-Si-Cu film, and an Al-Cu film is formed on the insulating layer 30 by, for example, a sputtering method. The aluminum-alloy film is then selectively removed by a known photolithography method to form the third wiring layers 31 and 32. In this event, the aluminum-alloy film is formed so as to bury the inside of the contact hole 33 to connect the second wiring layer 27 with the third wiring layer 31. Thereafter, the silicon nitride film layer 34 is deposited substantially all over the top surfaces of the third wiring layers 31 and 32 by, for example a plasma-enhanced chemical vapor deposition method carried out under a reduced pressure with a formation temperature of not higher than 450°C. The film thickness of the silicon nitride film layer 34 thus deposited is approximately 3000 to 10000 Å. Note that the surface of the insulating layer 30 is made to be flat by depositing a TEOS film, an SOG film, or the like.

What has been described in this embodiment is a manufacturing method in which the resistor 25 is formed, within a multi-layer wiring structure, in a region where the intermediate wiring layers are formed, but the embodiment of the invention is not limited to this method. For example, similar effects can be obtained also in a case where, within a multi-layer wiring structure, the resistor 43 is formed in a region where the wiring layers of the upper most surface are formed as shown in Fig. 3. Specifically, use of the above-described etchant in forming the wiring layers of the upper most surface prevents the over-etching of the resistor 43. Widening the separation distance between the resistor 43 and the epitaxial layer 3 can contribute to a reduction of the parasitic capacitance of the resistor and to an improvement of the high-frequency characteristics of the semiconductor device. In addition, what has been described in this embodiment is a case where the resistor 25 is made of a titanium nitride (TiN) film, but the material for the resistor 25 is not limited to this. For example, the resistor 25 may be made of a material which is not etched during the wet etching process of the wiring layers connected with the resistor and which has a high melting point. Specifically, a titanium (Ti) film, a tantalum (Ta) film, or a tantalum nitride (TaN) film may be used. Other modifications are possible without departing from the gist of the embodiment of the present invention.

In an aspect of the present invention, the resistor is directly connected with the wiring layer on the insulating layer. This structure increases the contact area between the resistor and the wiring layer, and reduces the contact resistance between the resistor and the wiring layer.

In an aspect of the invention, the resistor is formed of a film of a metal, such as titanium nitride (TiN), or the like. This structure allows the resistor to be disposed in a desired region on the insulating layer and to be separated away from the semiconductor layer. Accordingly, the parasitic capacitance of the resistor is reduced, and the high-frequency characteristics of the semiconductor device are improved.

In an aspect of the invention, the resistor is used as an etching-stopper film when the wiring layer connected with the resistor is wet-etched. By this manufacturing method, the resistor is prevented from being over-etched, and the variations in the resistance of the resistor can be prevented.

In an aspect of the invention, the resistor is made of a metal film, and the wiring layer connected with the resistor is removed by wet-etching. By this manufacturing method, the resistor is disposed, within the multi-layer wiring structure, in a region where the uppermost one of the wiring layers is formed. The parasitic capacitance of the resistor is reduced, and the high-frequency characteristics of the semiconductor device are improved.

## Claims

1. A semiconductor device comprising:
a semiconductor layer (3);
an insulating layer (26, 30) disposed on the semiconductor layer (3);
a resistor (25, 43) disposed on and being physically in contact with the insulating layer (26, 30); and
a wiring layer (28, 41) disposed on and being physically in contact with the insulating layer (26, 30),
wherein the resistor (25, 30) and the wiring layer (28, 41) is electrically connected.

2. The semiconductor device of claim 1, wherein the resistor (25, 43) is formed of titanium, titanium nitride, tantalum or tantalum nitride.

3. The semiconductor device of claim 1 or 2, wherein the resistor (25, 43) is physically in contact with the wiring layer (28, 41).

4. The semiconductor device of claim 2, wherein the wiring layer is the uppermost wiring layer (41, 42) of a plurality of wiring layers disposed on the semiconductor layer (3).

5. The semiconductor device of claim 2, further comprising an additional wiring layer (31) that is disposed above or below the wiring layer (31).

6. The semiconductor device according to any of claims 1 to 5, further comprising another wiring layer (29, 42) disposed on the insulating layer (26, 30) so as to be physically in contact with one end of the resistor (25, 43), wherein the wiring layer (28, 41) is physically in contact with another end of the resistor (25, 43).

7. A method of manufacturing a semiconductor device comprising:
depositing an insulating layer (26, 30) on a semiconductor layer (3);
forming a resistor (25, 43) on the insulating layer (26, 30);
forming a metal layer on the resistor (25, 43);
wet-etching the metal layer using the resistor (25, 43) as an etching-stopper film so that a first metal wiring layer (28, 41) is physically in contact with one end of the resistor (25, 43) and a second metal wiring layer (29, 42) is physically in contact with another end of the resistor (25, 43).

8. The method of claim 7, further comprising forming a MOS transistor (1) on the semiconductor layer (3) so that the insulating layer (26, 30) is disposed above a gate electrode (11, 12) of the MOS transistor (1).

9. The method of claim 7 or 8, wherein the resistor (25, 43) is formed of titanium, titanium nitride, tantalum or tantalum nitride.
